# EUROPEAN PATENT APPLICATION

(11) **EP 1 498 889 A1**
(43) Date of publication of application: **19.01.2005**
(21) Application number: 03715702.1
(22) Date of filing: 01.04.2003
(51) Int. Cl.: G11B 7/26, C23C 14/56

(54) **METHOD OF DELIVERING SUBSTRATES TO A FILM FORMING DEVICE FOR DISK-LIKE SUBSTRATES, SUBSTRATE DELIVERING MECHANISM AND MASK USED IN SUCH METHOD, AND DISK-LIKE RECORDING MEDIUM PRODUCING METHOD USING SUCH METHOD**

(30) Priority: 04.04.2002 JP 2002102034
(71) Applicant: TDK Corporation, Chuo-ku, Tokyo 103-8272 (JP)
(72) Inventor: KOSHIKAWA, Masato, c/o TDK Corporation, Tokyo 103-8272 (JP); ISHIZAKI, Hideki, c/o TDK Corporation, Tokyo 103-8272 (JP); MATSUI, Satoshi, c/o TDK Corporation, Tokyo 103-8272 (JP)
(74) Representative: Grünecker, Kinkeldey, Stockmair & Schwanhäusser Anwaltssozietät
(86) International application number: PCT/JP2003/004168
(87) International publication number: WO 2003/085659

(57) **Abstract**

The present invention has as its object the provision of a substrate delivering method enabling a disk-shaped substrate or the like having no central hole to be held in the atmosphere, and be easily placed on a sputtering apparatus. In the present invention, projected portions are provided on the central portions of the opposite surfaces of the disk-shaped substrate and the substrate is subjected to conveyance or the like while being made integral with a mask by substrate fixing means. Also, in a delivering mechanism, the substrate and the mask are held by the holding of the mask by a magnetic force and the gripping of the projected portion on the front surface of the substrate by substrate holding means, and also in a substrate holder to which the substrate is delivered, the holding of the mask by the magnetic force and the gripping of the projected portion on the back surface of the substrate are effected at a time, and during the delivery, a reduction in the magnetic force and the release of the gripping on the delivering mechanism side are effected substantially at a time.

## Description

### TECHNICAL FIELD

This invention relates to a thin film forming apparatus for forming thin film on a disk-shaped substrate, and more particularly to a method of effecting the delivery of a disk-shaped substrate used in the apparatus to the apparatus, and a mechanism for use in this method. The present invention also relates to a disk-shaped recording medium manufacturing method of manufacturing a disk-shaped recording medium such as a so-called optical disk by the use of a mask used with the mechanism, and the mechanism.

### BACKGROUND ART

As recording media manufactured with various kinds of thin film formed on a disk-shaped substrate, and particularly recording media having a disk-like shape, there are various disks including, for example, CD type disks such as CD, CD-R and CD-RW, or optical disks like DVD type disks such as DVD-ROM and DVD-R, or magneto-optical disks such as MO and MD. These disks are manufactured by laminating thin film on a substrate comprising, for example, a material such as polycarbonate by the use of one of various methods such as a sputtering method and a spin coat method.

Generally, the substrate which is the material of these disks is already formed with a through-hole in the central portion thereof during the supply thereof. In the subsequent thin film forming process, handling such as the carrying of the substrate into and out of a film forming apparatus or the like, and the positioning of the substrate in the film forming apparatus or the like is usually effected by the use of the central hole. The presence of this central hole, however, may deteriorate, for example, the distribution of the film thickness or film nature of the thin film on the substrate. Therefore, generally, film forming is effected with the central hole covered with a cap or the like, and with the influence of the presence thereof upon the film forming process minimized.

For example, during the manufacture of a DVD type disk, thin film formed of ultraviolet ray curing resin is formed as the constituent film thereof by the use of the spin coat method. Specifically, a substrate is carried on a rotatable table so that the center thereof and the center of rotation of the table may be made coincident with each other. Therefore, the positioning and fixing of the substrate relative to the table are done by an operation such as using such a rotary shaft as extends through the central hole, or disposing a cap fixed concentrically with the center of rotation of the table in the central hole of the disk.

Next, the dripping of the resin is continuously effected onto the disk in rotation, from the vicinity of the central hole or the end portion of the cap toward the outer periphery of the disk. The dripped resin is diffused by a centrifugal force resulting from the rotation of the disk, and as the result, the forming of thin film of resin is effected on the surface of the substrate. The resin which has become the thin film is thereafter made into stable film structure via a step such as the application of an ultraviolet ray.

In this case, the dripping of the resin cannot help being effected to a location off the center of rotation and therefore, the distribution of film thickness attributable thereto has occurred. At present, however, a red laser beam generally used for the reading or the like of records has a relatively long wavelength and therefore, this distribution has been within an allowable range. When in the future, for example, a blue laser beam of a short wavelength is used to more enhance the recording density of an optical disk, it will become necessary to obtain thin film of higher uniformity.

Also, metal thin film or the like used in reflecting film or the like is formed by the use of a sputtering method. In this method, a disk-shaped substrate is fixed to and held on the front of a target in a vacuum chamber with its central hole portion and the outer peripheral portion thereof covered with a jig. Generally, a certain voltage is applied to this target, whereby discharge occurs between the target and the substrate and plasma occurs. The constituent element of the target in the surface of the target is sputtered by ions in the plasma, and the sputtered particles adhere to the surface of the substrate, whereby film forming is effected.

If in that case, a jig for fixing the substrate contacts with the surface of the substrate, abnormal discharge may occur between thin film and the jig during film forming. This is because charges accumulated in the thin film or the surface of the jig by discharge are discharged from the point of contact between the jig and the surface of the film. Also, if the jig juts out into a discharge space, the presence thereof may distort an electric field with a result that influence may also be given to the distribution of the film thickness. Therefore, it is preferable that the surface of the substrate and the jig be always held with a constant minute interval kept therebetween, and if possible, it is preferable that the jig itself be not used.

### DISCLOSURE OF THE INVENTION

The applicant has proposed a manufacturing process using a substrate formed with no hole in the central portion thereof as means for solving the above-noted problems, that is, as a method of more improving the distribution of film thickness in a process using the spin coat method. When such substrate is used, the number of jigs used for the fixing of the substrate during sputtering decreases and therefore, it becomes easy to keep the interval between the surface of the substrate and the jig constant, and a reduction in abnormal discharge is also considered to become easy.

However, the transportation of the substrate to the vicinity of a sputtering apparatus, the conveyance thereof to the interior of this apparatus, the holding of the substrate during film forming, the carrying of the substrate out of the apparatus after the film forming, etc. are effected by the use of the outer periphery of the substrate and a central hole formed in the substrate. Therefore, the inventor has proposed a novel substrate chucking method in the sputtering apparatus.

However, when a series of film forming steps are to be automated, it is also necessary to prepare a substrate conveying mechanism or the like which can reliably effect the above-mentioned transportation or the like of the substrate. The present invention has been devised for this task, and has as its object to provide a substrate delivering method which reliably holds and transport a substrate in the atmosphere, and can safely effect the delivering and receipt or the like of the substrate with a thin film forming apparatus such as a sputtering apparatus, and a delivering mechanism or the like which embodies this method.

Also, as regards the above-described disk, with the outer peripheral portion covered with a so-called outer mask, the forming of thin film on the surface thereof is effected by sputtering. Thin film adheres to this outer mask during film forming on the substrate as it adheres to the substrate and therefore, when the thin film has been laminated to a suitable thickness, it is necessary to effect the removal thereof. Therefore, with the outer mask fixed to the substrate, the carrying of the substrate into and out of the sputtering apparatus is effected.

The substrate delivering method according to the present invention also pays attention to the outer mask, and has as its object to make the reliable maintenance of the relative relation between the outer mask and the substrate possible during the conveyance of the substrate. Further, the present invention provides a thin film forming apparatus such as a sputtering apparatus which embodies this delivering method, and a disk-shaped recording medium manufacturing method using the same apparatus.

In order to solve the above-noted problems, a substrate delivering method according to the present invention is a method of delivering a disk-shaped substrate having a first projected portion on the center of the front surface thereof and having a second projected portion on the center of the back surface thereof to a substrate holder together with a mask covering the outer peripheral portion of the substrate, characterized by fixing and holding the surface of the mask in advance to the substrate holding surface of a conveying arm by a magnetic force, holding the first projected portion by substrate holding means in the arm provided on the central portion of the substrate holding surface, opposing the substrate holder to the substrate holding surface of the conveying arm holding the mask and the substrate, inserting the second projected portion into a recess formed at the center of the substrate holder, fixing the substrate to the holder by substrate holding means in the holder provided in the recess, effecting a reduction in a magnetic force given from the conveying arm to the mask and the release of the holding of the first projected portion by the substrate holding means in the arm, and fixing and holding the back surface of the mask to the holder by a magnetic force generated from the substrate holder.

In the above-described method, the substrate is fixed to the mask by substrate fixing means in the mask provided in the mask, and it is preferable that the delivery of the substrate be effected with the substrate and the mask as a unit. Also, in the above-described method, it is preferable that the substrate holding means in the arm comprise a collect chuck.

Also, in order to solve the above-noted problems, the mask according to the present invention is a mask for covering the outer peripheral portion of the surface of a substantially disk-shaped substrate when film forming is effected on the surface of the substrate, characterized by a ring-shaped mask main body having an inner diameter larger than the outer periphery of the substrate, a mask flange portion connecting to the mask main body and having a shape in which one end surface of the mask extends toward the inner peripheral side thereof and the end surface is inclined to the other end surface side thereof toward the inner peripheral end portion thereof, and substrate fixing means in the mask provided in the mask for biasing the end portion of the substrate toward substantially the center of the substrate, and sandwiching the end portion of the substrate between it and the mask flange to thereby fix the relative position of the substrate and the mask. In this mask, it is preferable that the substrate fixing means in the mask include a ball plunger.

Also, in order to solve the above-noted problems, the substrate delivering mechanism according to the present invention is a substrate delivering mechanism for holding a substantially disk-shaped substrate having a projected portion on the central portion thereof, and shifting the substrate onto other substrate holding mechanism, characterized by substrate holding means provided on a substrate holding surface for holding the substrate, and for fixing and holding the projected portion, and a magnet for fixing and holding a mask disposed substantially at the outer peripheral end portion of the substrate and having had its relative positional relation with the substrate made constant around the substrate holding means on the substrate holding surface by a magnetic force.

In the above-described delivering mechanism, it is preferable that the holding of the substrate by the substrate holding means and the holding of the mask by the magnet be released substantially at the same timing. Further, in the delivering mechanism, it is preferable that the substrate holding means comprise a collect chuck.

Also, in order to solve the above-noted problems, the disk-shaped recording medium manufacturing method according to the present invention is characterized by using a substantially disc-shaped substrate having a first projected portion on the central portion of the front surface thereof and having a second projected portion on the central portion of the back surface thereof, fixing and holding the surface of a mask covering the outer peripheral end portion of the substrate to the substrate holding surface of a substrate covering arm by a magnetic force, holding the first projected portion by substrate holding means in the arm provided in the central portion of the substrate holding surface, opposing a substrate holder to the substrate holding surface of the conveying arm holding the mask and the substrate, inserting the second projected portion into a recess formed at the center of the substrate holder, fixing the substrate to the holder by substrate holding means in the holder provided in the recess, effecting a reduction in a magnetic force given from the conveying arm to the mask and the release of the holding of the first projected portion by the substrate holding means in the arm, fixing and holding the back surface of the mask to the holder by a magnetic force generated from the substrate holder, conveying the substrate holder holding the substrate and the mask to a thin film forming position in a thin film forming apparatus, and forming thin film on the substrate.

In the above-described manufacturing method, it is preferable that the substrate and the mask covering the outer peripheral end portion of the film forming surface of the substrate be made into a unit by substrate fixing means in the mask provided in the mask, and the transportation thereof from the substrate conveying arm to the thin film forming apparatus be effected.

### BRIEF DESCRIPTION OF THE DRAWINGS

Fig. 1 relates to a substrate delivering mechanism according to the present invention, and schematically shows the construction of a substrate holder holding a substrate and a mask in a cross section thereof.
Fig. 2A schematically shows the construction of a conveying arm in the atmosphere which is the substrate delivering mechanism according to the present invention in a cross section thereof.
Fig. 2B shows the state of a chuck shaft as it is seen from the front thereof.
Fig. 3 shows a substrate delivering method according to the present invention.
Fig. 4 shows the substrate delivering method according to the present invention.
Fig. 5 shows the substrate delivering method according to the present invention.
Fig. 6 shows the substrate delivering method according to the present invention.

### BEST MODE FOR CARRYING OUT THE INVENTION

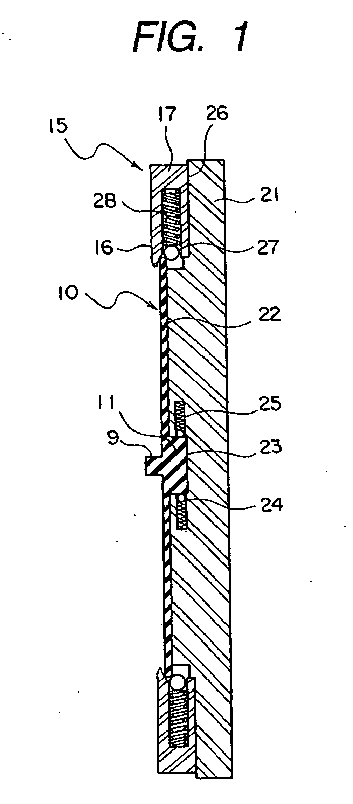

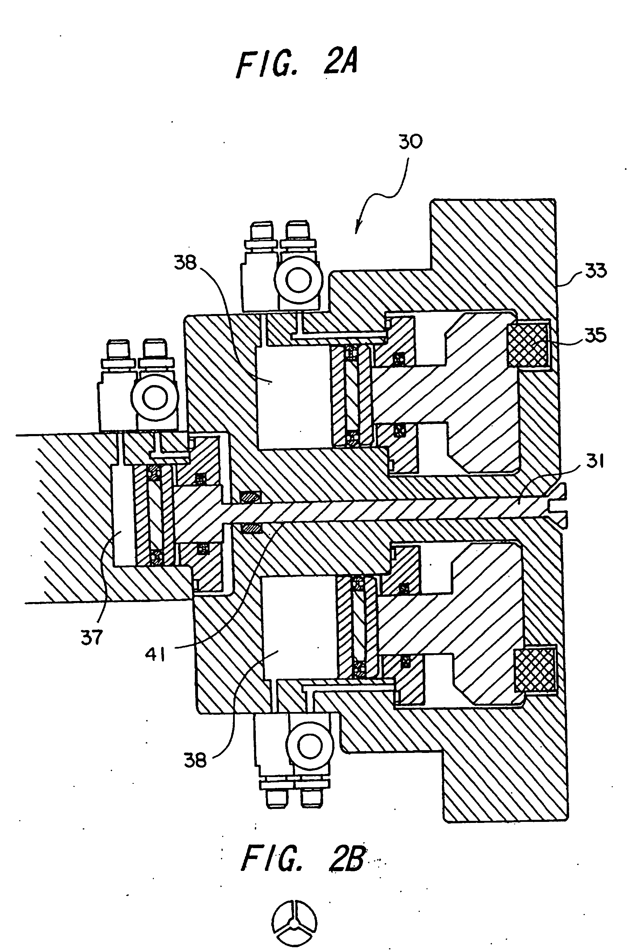

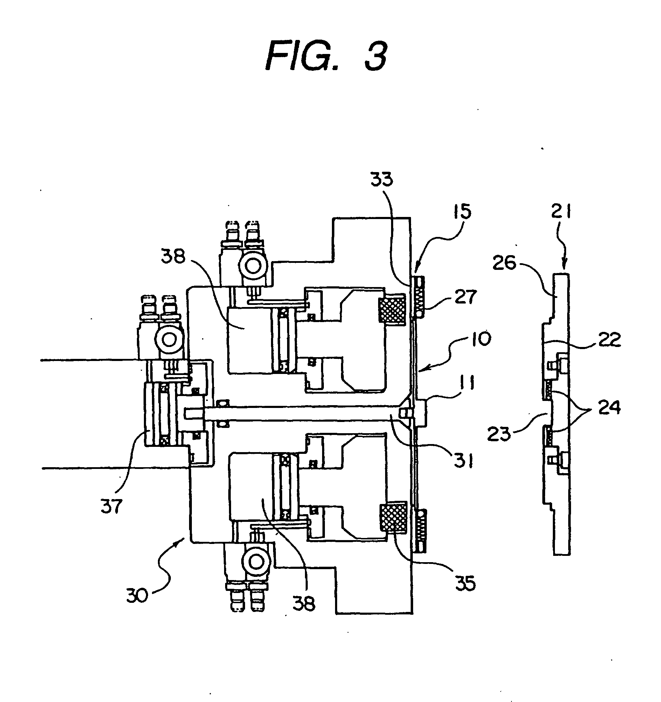

A substrate delivering mechanism, etc. according to the present invention will hereinafter be described in detail. Fig. 1 shows a substantially cross-sectional view of a substrate holder holdable with a substrate by the delivering mechanism and actually holding the substrate during film forming in a sputtering apparatus or the like, and the substrate held by the holder. Also, Fig. 2A shows a substantially cross-sectional view of an atmosphere side conveying arm having the substrate delivering mechanism substantially rightly opposed to the substrate holder holding the substrate, and effecting the delivery of the substrate between it and the substrate holder. Further, Figs. 3 to 6 show substantially cross-sectional views showing states in which the delivery of the substrate is effected by these constructions.

The substrate 10 used in the present invention is of a substantially disk-like shape, and is formed with a first projected portion 9 on the central portion of the film forming surface thereof, and a second projected portion 11 on the central portion on the back of the film forming surface. Each of these projected portions has a substantially columnar shape in which the axis thereof coincides with the center of the substrate. The substrate holder 21 held by a vacuum side conveying arm or the like, not shown, in the sputtering apparatus is comprised of a substrate receiving portion 22 corresponding to the back surface of the substrate, and a mask receiving portion 26 disposed on the outer periphery thereof. The substrate receiving portion 22 has a substantially circular flat surface and a recess 23 provided at the center thereof and having a cylindrical inner surface.

As shown in Fig. 1, in the recess 23, a ball plunger 24 provided so as to drive in a direction perpendicular to the axis of the cylinder thereof is disposed about the axis. When the substrate holder 21 holds the substrate 10, the second projected portion 11 on the back surface of the substrate is inserted into the recess 23, and is fixed and supported by the ball plunger 24 which is substrate fixing means in the holder. At that time, the ball plunger 24 is supported so that the axis of the second projected portion 11 and the axis of the recess 23 may coincide with each other by the action of the biasing force of a spring 25.

A mask 15 has a ring-shaped mask main body 17 having an inner diameter larger than the outer diameter of the substrate, and a mask flange portion 16 jutting out from one end portion thereof to the inner peripheral side thereof for covering the outer peripheral end portion of the substrate 10. Also, in the mask main body 17, a ball plunger 27 in the mask is disposed toward the inner peripheral surface of the ring as substrate holding means for sandwiching the substrate 10 between it and the mask flange portion 16, and holding and fixing the substrate to the mask 15.

The mask flange portion 16 requires the mask main body 17 supporting it and the substrate 10 to have widths enabling such an interval as will not cause abnormal charge during the film forming by sputtering. Also, in order to minimize the influence given to an electric field during the film forming, the mask flange portion is provided with a tapered portion so as to be inclined toward the other end surface of the mask main body as it approaches the inner peripheral end portion thereof.

Also, it is necessary for the inner peripheral end portion of the mask flange 16 to keep a minute interval of a predetermined value or less in order to prevent the occurrence of abnormal discharge between it and the surface of the substrate 10 during the film forming by sputtering, and avoid the contact between these. Therefore, it is required to determine the thickness of the mask main body 17 and the thickness of the mask flange portion 16 or a method of supporting the mask 15 in conformity with a discharging condition so as to satisfy these requirements when the mask 15 is supported on the mask receiving portion 26.

Also, the ball plunger 27 in the mask which is substrate fixing means in the mask biases the substrate 10 by a spring 28 in the mask so as to make the center thereof coincident with the mask 15. At the same time, the ball plunger 27 in the mask sandwiches the end portion of the substrate 10 between it and the mask flange portion 16 to thereby make the relative positional relation between the mask 15 and the substrate 10 always constant.

In the present embodiment, the mask 15 is fixed and held in close contact with the mask receiving portion 26 by a magnetic force generated by a magnet, not shown, located in the mask receiving portion 26. The back surface of the substrate 10 is held in close contact with a substantially circular flat surface formed as a holder substrate receiving portion 22 by the mask 15 being brought into close contact with the substrate holder 21 by the aforementioned magnet. Also, the substrate 10 is heated by radiation heat or the like received from plasma during film forming, and the center of the substrate is deformed in a direction away from the substrate receiving portion 22 by thermal expansion. In the substrate holder 21, the second projected portion 11 is fixed and gripped in the recess 23 by an urging force received from the spring 25 through the ball plunger 24 to thereby achieve the suppression of this deformation.

As shown in Fig. 2A, an atmosphere side conveying arm 30 which is a substrate delivering mechanism has a chuck shaft 31 as substrate holding means in the arm for gripping the first projected portion 9 of the substrate 10, and a mask holding portion 33 for holding the mask 15 in the surface thereof by the action of a magnet 35. The mask holding portion 33 is fixed to the atmosphere side conveying arm 30, and the magnet 35 giving a magnetic force to the mask 15 and causing it to be attracted to the mask holding portion and the chuck shaft 31 are drivable to the atmosphere side conveying arm 30 by an air cylinder 38 for the magnet and an air cylinder 37 for the chuck, respectively.

The chuck shaft 31 has a conical shape of which the diameter becomes larger toward the end portion thereof, and as shown in the front view of Fig. 2B, is formed with an axially extending hole and slits equiangularly around it. The conveying arm 30 is formed with a through-hole 41 through which the chuck shaft extends. The opening portion of this through-hole 41 which is adjacent to the mask holding portion 33 is provided with a tapered portion corresponding to the shape of the end portion of the chuck shaft 31. These constructions form a collect chuck in which when the chuck shaft 31 is axially driven, the slits in the tip end portion thereof are closed to thereby grip an object inserted into the hole.

Description will hereinafter be made of the operation when the substrate 10 held by the atmosphere side conveying arm 30 is delivered to the vacuum side conveying arm 20. In case of the transportation of the substrate in the present invention, the substrate 10 and the mask 15 have their positional relation determined by the action of the ball plunger 27 in the mask, and the transportation thereof is always effected as a unit. First, as shown in Fig. 3, the substrate holder 21 not holding the substrate 10 and the mask 15, and the atmosphere side conveying arm 30 in which the first projected portion 9 is gripped by the chuck shaft 31 and which holds the mask 15 on the mask holding portion 33 by the action of the magnet 35 are rightly opposed to each other.

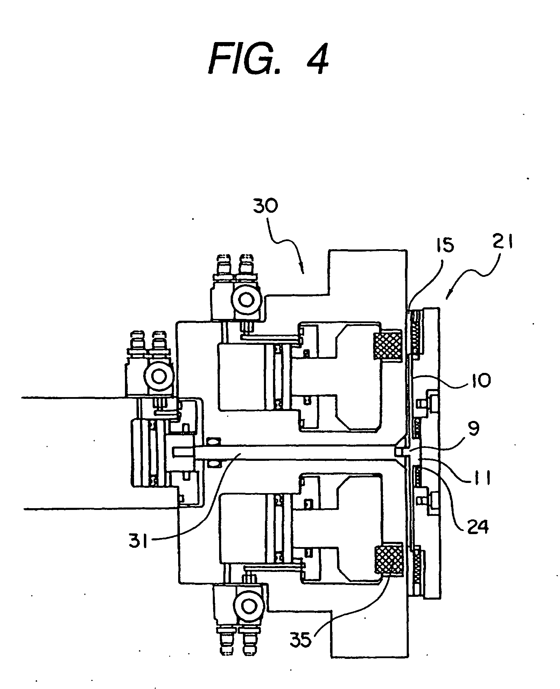

In this state, the atmosphere side conveying arm 30 approaches the substrate holder 21 held by the vacuum side conveying'arm, not shown, and is stopped in a state in which the interval therebetween has become a predetermined interval. This state is shown in Fig. 4. At that time, the second projected portion 11 of the substrate is inserted into the recess 23 in the substrate receiving portion 22 of the vacuum side conveying arm 20, and the tip end thereof becomes located in the inner part of the recess deeper than the ball plunger 24.

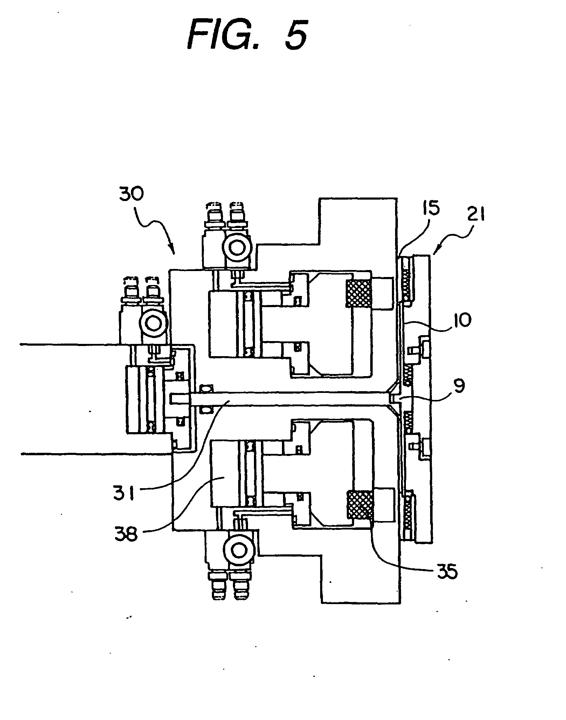

Subsequently, as shown in Fig. 5, the chuck shaft 31 is driven toward the mask holding portion 33 by the air cylinder 37 for the chuck, and the gripping of the first projected portion 9 by the chuck shaft 31 is released. At the same time, the magnet 35 is retracted by the air cylinder 38 for the magnet, and the mask 15 becomes detachable from the mask holding portion 33. In this state, a magnet force from the magnet, not shown, in the mask receiving portion 26 is already acting on the mask 15 and therefore, the mask 15 is attracted to and held by the mask receiving portion without changing its posture.

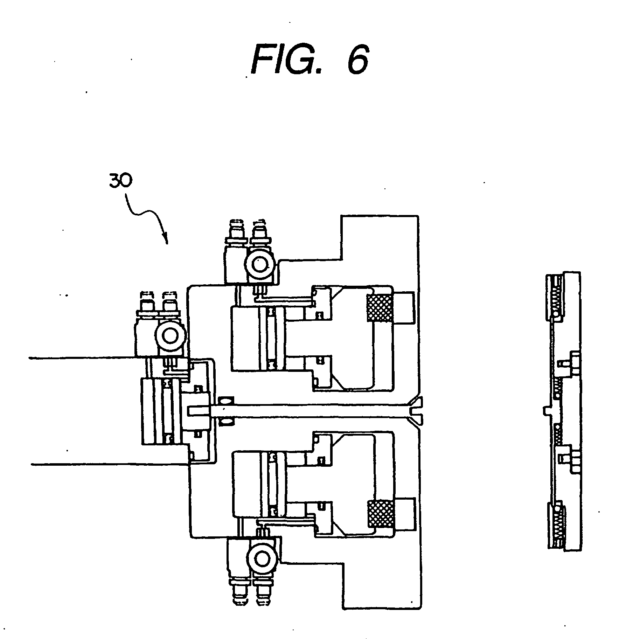

Thereafter, as shown in Fig. 6, the atmosphere side conveying arm 30 is retracted, and the substrate holder 21 holding the substrate 10 and the mask 15 is conveyed to the sputtering apparatus by the vacuum side conveying arm, not shown, and a film forming process is executed. After the termination of the film forming process, the substrate holder 21 holding the substrate 10 on which film has been formed is returned to a position rightly opposed to the atmosphere side conveying arm 30, and the delivery of the substrate 10 from the vacuum side conveying arm to the atmosphere side conveying arm 30 is effected by a procedure converse to the above-described delivery of the substrate 10.

By adopting the above-described construction, it becomes possible to easily and reliably effect the carrying of the substrate 10 onto the substrate holder 21 and the attachment of the mask 15 to these even if use is made of a substrate having no central hold. Further, it becomes easy to make the interval between the inner peripheral end portion of the mask and the surface of the substrate into a predetermined value and it also becomes possible to decrease abnormal discharge or the like. The first projected portion 9 provided on the substrate 10 protrudes relative to an electric field, but basically it is formed of an insulating material and therefore, the influence thereof is small as compared with that of an electrical conductor, and the size thereof is made suitable, whereby it is possible to make the influence thereof during film forming sufficiently small.

While in the present embodiment, the acting direction of the ball plunger 24 is a direction perpendicular to the axis of the recess 23, the present invention is not restricted thereto, but the ball plunger can be made to act in a direction differing from the direction of the axis. Also, while three ball plungers 24 are disposed for a recess 23, the number thereof is not limited to three if it is possible to fix and support the projected portion 11 at the center of the recess. Also, while the ball plunger is used for the fixing and holding of the projected portion 11, this construction is not restricted to the ball plunger if it is any one having similar action.

Also, in the present embodiment, the ball plungers 27 in the mask provided in the mask main body 17 are equiangularly provided so that the acting direction thereof may be the central portion of the ring shape thereof. The number of the ball plungers 27, however, is not particularly prescribed, but the ball plungers can be any ones which fix and support the substrate 10 substantially at the center of the ring shape, and for example, one ball plunger and a positioning projection can simply be provided on the inner periphery of the ring. Also, while the ball plungers are used for the fixing and holding of the substrate 10, this construction is not restricted to the ball plungers if it has similar action.

Also, while in the present embodiment, the so-called collect chuck is used as the substrate holding means in the arm, the present invention is not restricted thereto, but it is possible to assume one of various forms in which a screw groove is formed in the projected portion and the substrate is fixed by this screw, or the projected portion is vacuum-attracted. Also, while the air cylinders are used for the driving of the chuck shaft or the magnet, but it is possible to use one of various driving mechanisms instead of these.

Also, while the sputtering apparatus has been mentioned as a thin film forming apparatus which becomes a subject when the present invention is used, the application of the present invention is not restricted thereto, but it is possible to apply the present invention to various thin film forming apparatuses such as a vapor-depositing apparatus and a CVD apparatus. Also, the present invention is not only used simply as a manufacturing method for an optical disc or the like, but also is applicable to a manufacturing process for products which are later subjected to the step of removing the central portion, for example, all of disk-shaped members such as hard disks.

By carrying out the present invention, it becomes possible to hold a disk-shaped substrate having no central hole in stable close contact with the holder. Thereby, not only in the film forming process by the spin coat method, but also in the film forming process by the sputtering method, it becomes possible to effect thin film forming on a disk-shaped substrate having no central hole, and it becomes possible to obtain thin film which is higher in the uniformity of film thickness and film nature. Also, by decreasing holding parts for the substrate in the sputtering method, it becomes possible to achieve a reduction in abnormal discharge in the film forming process.

Further, by carrying out the present invention, it becomes possible to reliably hold and transport the substrate in the atmosphere, and safely effect the delivery and receipt or the like of the substrate with respect to the sputtering apparatus, and the automation of a series of film forming processes becomes easy. Also, with the relative positional relation between the substrate and the outer mask fixed, the carrying of these into and out of the sputtering apparatus is effected and therefore, it becomes possible to easily suppress the occurrence of abnormal discharge by the mask, or the occurrence of the influence or the like of the mask upon the distribution of film thickness or the like.

## Claims

1. A substrate delivering method of delivering a disk-shaped substrate having a first projected portion on the center of a front surface thereof and having a second projected portion on the center of a back surface thereof to a substrate holder together with a mask covering an outer peripheral portion of said substrate, comprising:
fixing and holding a front surface of said mask in advance to a substrate holding surface of a conveying arm by a magnetic force, and holding said first projected portion by substrate holding means in the arm provided in the central portion of said substrate holding surface;
opposing said substrate holder to the substrate holding surface of said conveying arm holding said mask and said substrate;
inserting said second projected portion into a recess formed at the center of said substrate holder, and fixing said substrate to said substrate holder by substrate holding means in the holder provided in said recess;
effecting a reduction in a magnetic force given from said conveying arm to said mask and the release of the holding of said first projected portion by said substrate holding means in the arm; and
fixing and holding a back surface of said mask to said substrate holder by a magnetic force generated from said substrate holder.

2. A method according to Claim 1, wherein said substrate is fixed to said mask by substrate fixing means in the mask provided in said mask, and the delivery of said substrate is effected with said substrate and said mask as a unit.

3. A method according to Claim 1, wherein said substrate holding means in the arm comprises a collect chuck.

4. A mask for covering an outer peripheral portion of a front surface of a substantially disk-shaped substrate when film forming is effected on the front surface of the substrate, having:
a ring-shaped mask main body having an inner diameter larger than the outer periphery of said substrate;
a mask flange portion connecting to said mask main body, and having a shape in which one end surface of said mask juts toward an inner peripheral side and said one end surface is inclined to the other end surface side toward an inner peripheral end portion of the mask; and
substrate fixing means in the mask provided in said mask main body for biasing an end portion of said substrate toward substantially the center of said substrate, and sandwiching the end portion of said substrate between it and said mask flange portion and fixing the relative position of said substrate and said mask.

5. A mask according to Claim 4, wherein said substrate fixing means in the mask includes a ball plunger.

6. A substrate delivering mechanism for holding a substantially disk-shaped substrate having a projected portion on the central portion thereof, and shifting said substrate to other substrate holding mechanism, having:
substrate holding means provided on a substrate holding surface holding said substrate for fixing and holding said projected portion; and
a magnet for fixing and holding a mask disposed substantially in an outer peripheral end portion of said substrate and having had its relative positional relation with said substrate made constant around said substrate holding means on said substrate holding surface by a magnetic force.

7. A substrate delivering mechanism according to Claim 6, wherein the holding of said substrate by said substrate holding means and the holding of said mask by said magnet are released substantially at the same timing.

8. A substrate delivering mechanism according to Claim 6, wherein said substrate holding means comprises a collect chuck.

9. A disk-shaped recording medium manufacturing method comprising:
using a substantially disk-shaped substrate having a first projected portion on a central portion of a front surface thereof and having a second projected portion on a central portion of a back surface thereof;
fixing and holding a front surface of a mask covering an outer peripheral end portion of said substrate to a substrate holding surface of a substrate conveying arm by a magnetic force, and holding said first projected portion by substrate holding means in the arm provided on a central portion of said substrate holding surface;
opposing a substrate holder to the substrate holding surface of said substrate conveying arm holding said mask and said substrate;
inserting said second projected portion into a recess formed at the center of said substrate holder, and fixing said substrate to said substrate holder by substrate holding means in the holder provided in said recess;
effecting a reduction in a magnetic force given from said substrate conveying arm to said mask and the release of the holding of said first projected portion by said substrate holding means in the arm;
fixing and holding a back surface of said mask to said substrate holder by a magnetic force generated from said substrate holder;
conveying said substrate holder holding said substrate and said mask to a thin film forming position in a thin film forming apparatus; and
forming thin film on said substrate.

10. A method according to Claim 9, wherein said substrate and the mask covering an outer peripheral end portion of a film forming surface of said substrate are made into a unit by substrate fixing means in the mask provided in said mask, and the transportation thereof from said substrate conveying arm to said thin film forming apparatus is effected.
